# DEMANDE DE BREVET EUROPEEN

(11) **EP 0 893 879 A1**
(43) Date de publication de la demande: **27.01.1999**
(21) Numéro de dépôt: 98401834.1
(22) Date de dépôt: 20.07.1998
(51) Int. Cl.: H03F 1/32

(54) **Dispositif de linéarisation d'amplificateurs d'émission**

(30) Priorité: 24.07.1997 FR 9709422
(71) Demandeur: ALCATEL ALSTHOM COMPAGNIE GENERALE D'ELECTRICITE, 75008 Paris (FR)
(72) Inventeur: Achard, Jacques, 92130 Issy les Moulineaux (FR); Couty, Richard, 95120 Ermont (FR); Gourgue, Frédéric, 75017 Paris (FR); Lebret, Yann-Yves, 75010 Paris (FR)
(74) Mandataire: El Manouni, Josiane

(57) **Abrégé**

Dispositif de linéarisation d'amplificateurs d'émission pour équipement émetteur comportant une pluralité d'émetteurs (11, 12, ...1n) comportant chacun un amplificateur d'émission (4) et non totalement découplés les uns des autres, ce dispositif comportant des moyens pour commander l'émission de signaux dits de linéarisation relatifs à chaque amplificateur, des moyens (6) pour analyser les signaux de linéarisation amplifiés correspondants, afin de déterminer les non linéarités de cet amplificateur, et d'appliquer à des signaux dits utiles une précorrection (5) destinée à compenser ces non linéarités, et ce dispositif étant essentiellement caractérisé en en ce qu'il comporte des moyens (8, 8', 10-20) dits de commande centralisée pour commander l'émission de signaux de linéarisation relatifs à différents amplificateurs d'émission à des moments différents.

## Description

La présente invention concerne d'une manière générale la linéarisation d'amplificateurs, notamment la linéarisation d'amplificateurs d'émission utilisés dans les équipements émetteurs des systèmes de radiocommunications, notamment des systèmes de radiocommunications mobiles.

Diverses techniques de linéarisation sont connues, notamment celles basées sur une pré-correction appliquée aux signaux à amplifier, en vue de compenser les distorsions non linéaires introduites lors de l'amplification de ces signaux.

Ces techniques de linéarisation basées sur une pré-correction nécessitent une connaissance préalable des non linéarités de l'amplificateur à linéariser. Ces non linéarités peuvent être déterminées une fois pour toutes, avant mise en service de cet amplificateur. Elles peuvent aussi être déterminées après mise en service de cet amplificateur, en émettant, lorsque cela est estimé nécessaire, des signaux de test, dits ici de linéarisation, et en analysant les signaux de linéarisation amplifiés correspondants, afin de déterminer les non linéarités de cet amplificateur, et d'appliquer à des signaux dits utiles à amplifier par cet amplificateur, une pré-correction correspondante.

Un problème se pose, lorsqu'un même équipement émetteur comporte plusieurs émetteurs non totalement découplés les uns des autres.

Une telle situation se rencontre notamment lorsque, pour augmenter la capacité d'un équipement émetteur, on prévoit à l'intérieur de celui-ci plusieurs émetteurs, émettant dans des bandes de fréquence différentes, ces émetteurs pouvant soit être raccordés à une même antenne par l'intermédiaire d'un élément appelé coupleur, soit être raccordés séparément à des antennes distinctes. Ces émetteurs n'étant pas parfaitement isolés les uns des autres, soit parce que le coupleur utilisé n'est pas un composant idéal, soit simplement du fait de la proximité géographique des différentes antennes, des signaux de linéarisation transmis par différents émetteurs peuvent interférer les uns avec les autres. Les non linéarités de chacun de ces amplificateurs d'émission ne peuvent plus alors être correctement déterminées.

Pour résoudre ce problème, il est possible d'isoler plus efficacement ces émetteurs les uns des autres en utilisant des filtres à très forte atténuation. De tels filtres sont cependant coûteux et volumineux. Une telle isolation peut en outre être très difficile, voire impossible, à réaliser pour des émetteurs opérant dans des bandes de fréquence voisines, du fait de la trop grande sélectivité requise.

Une autre solution consisterait à utiliser un coupleur de meilleure qualité, mais on retrouve alors le même inconvénient de coût que dans la solution précédente, ou à éloigner suffisamment les antennes, mais ceci ne constitue pas une solution réaliste.

La présente invention a essentiellement pour but d'apporter une solution à ce problème, permettant d'éviter ces inconvénients, tout en étant simple à mettre en oeuvre.

La présente invention est applicable à tout système, qu'il soit ou non du type dit à accès multiple, et, dans le cas de système à accès multiple, quel que soit le type d'accès multiple, notamment TDMA (pour "Time Division Multiple Access"), FDMA (pour "Frequency Division Multiple Access") ou CDMA (pour "Code Division Multiple Access").

La présente invention a ainsi essentiellement pour objet un dispositif de linéarisation d'amplificateurs d'émission pour équipement émetteur comportant une pluralité d'émetteurs comportant chacun un amplificateur d'émission et non totalement découplés les uns des autres, ce dispositif comportant des moyens pour commander l'émission de signaux dits de linéarisation relatifs à chaque amplificateur, et des moyens pour analyser les signaux de linéarisation amplifiés correspondants, afin de déterminer les non linéarités de cet amplificateur, et d'appliquer à des signaux dits utiles à amplifier par cet amplificateur une précorrection destinée à compenser ces non linéarités, et ce dispositif étant essentiellement caractérisé en en ce qu'il comporte des moyens dits de commande centralisée pour commander l'émission de signaux de linéarisation relatifs à différents amplificateurs d'émission à des moments différents.

D'autres objets et caractéristiques de la présente invention apparaîtront à la lecture de la description suivante d'exemples de réalisation, faite en relation avec les dessins ci-annexés, dans lesquels:
- la figure 1 est un schéma destiné à illustrer un équipement émetteur utilisant un dispositif de linéarisation suivant l'invention,
- la figure 2 est un schéma destiné à illustrer un exemple de structure temporelle de transmission, correspondant plus particulièrement au cas d'un système à accès multiple par répartition temporelle (ou "TDMA"), afin d'illustrer le principe de transmission de signaux de linéarisation dans un tel système,
- la figure 3 est un schéma destiné à illustrer le principe de transmission de signaux de linéarisation dans un système autre qu'un système à accès multiple par répartition temporelle,
- la figure 4 est un schéma destiné à illustrer une variante de réalisation du schéma de la figure 1,
- la figure 5 est un schéma destiné à illustrer une autre variante de réalisation du schéma de la figure 1.

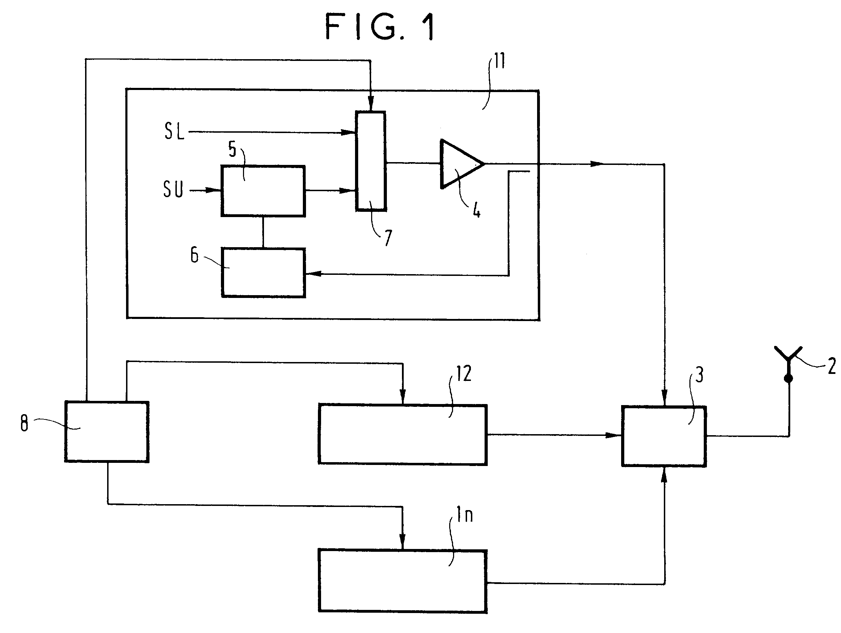

L'équipement émetteur illustré sur la figure 1 comporte un ensemble d'émetteurs notés 11, 12, ...1n, raccordés en l'occurrence à une même antenne 2 par l'intermédiaire d'un coupleur 3. Pour simplifier, un seul de ces émetteurs, 11, a été illustré plus en détail, les autres étant identiques.

L'émetteur 11 comporte un amplificateur d'émission 4, précédé d'un dispositif de pré-correction 5.

L'amplificateur d'émission 4 reçoit, outre des signaux utiles SU, des signaux de linéarisation SL, ces signaux SU et SL lui étant appliqués à travers des moyens 7 dits de multiplexage, ces moyens 7 étant notamment inclus dans des moyens permettant de réaliser l'accès multiple souhaité dans le cas d'un système à accès multiple.

Les signaux de linéarisation amplifiés sont analysés par un dispositif d'analyse 6 pour en déduire la fonction de transfert du dispositif de pré-correction 5, c'est-à-dire la pré-correction à apporter aux signaux utiles SU, pour compenser les non linéarités de l'amplificateur d'émission 4.

Dans un système à accès multiple par répartition temporelle, la structure temporelle de transmission utilisée est telle que différents canaux temporels logiques sont affectés à la transmission de différents types de signaux (tels que des signaux de trafic, de contrôle, de signalisation,...etc.), chacun de ces canaux logiques se décomposant en une succession de canaux temporels physiques, ou intervalles de temps, dans lesquels peuvent être transmis des éléments de signaux appelés paquets (ou "bursts"). Un de ces canaux logiques, dit canal logique de linéarisation, est affecté à la transmission de signaux de linéarisation.

L'équipement émetteur considéré comporte en outre, suivant l'invention, des moyens dits de commande centralisée 8 qui, dans un tel système à accès multiple par répartition temporelle, sont des moyens pour commander l'émission de paquets de linéarisation relatifs à différents amplificateurs d'émission dans des canaux temporels physiques distincts dudit canal temporel logique de linéarisation.

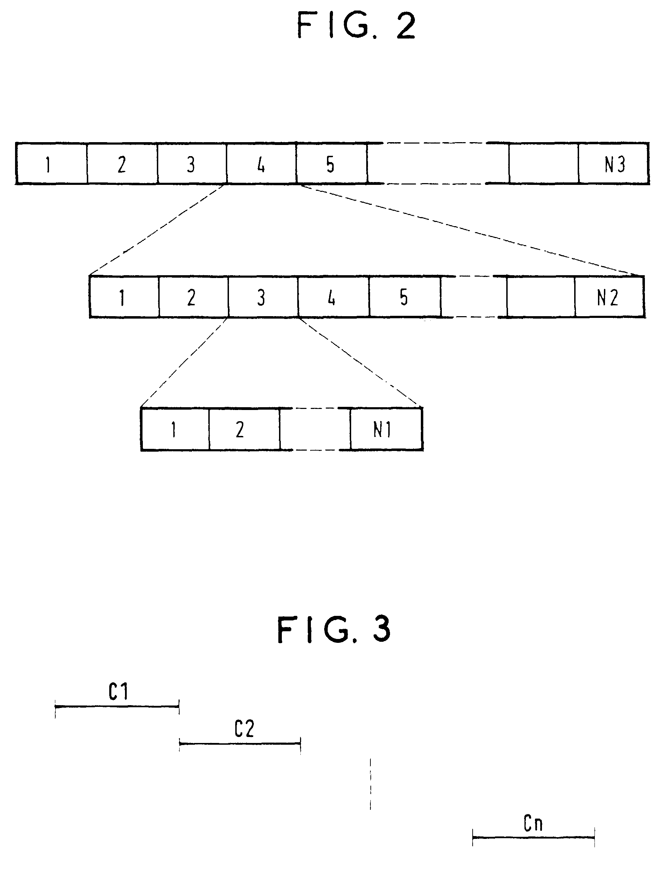

Pour illustrer le principe d'une telle émission de paquets de linéarisation, on se réfère à la figure 2 qui illustre un exemple de structure temporelle possible. A titre d'exemple, le cas d'une structure temporelle à trois niveaux a été illustré:
- un premier niveau correspondant à une trame formée de N1 intervalles de temps (ou IT),
- un deuxième niveau correspondant à une multitrame formée de N2 trames,
- un troisième niveau correspondant à une hypertrame trame formée de N3 multitrames.

Cette structure est en outre répétitive et, dans cet exemple, un canal temporel logique peut être formé soit des intervalles de temps de même rang i (avec i compris entre 1 et N1) de trames successives, soit des intervalles de temps de même rang i d'une trame donnée de multitrames successives, soit des intervalles de temps de même rang i d'une trame et d'une multitrame données d'hypertrames successives.

Ainsi, si le canal logique de linéarisation est par exemple formé des intervalles de temps de même rang i d'une trame donnée de multitrames successives, l'intervalle de temps de rang i d'une trame donnée de la première multitrame d'une hypertrame pourra par exemple être affecté à la transmission d'un paquet de linéarisation de l'amplificateur d'émission de l'émetteur 11, l'intervalle de temps de rang i d'une trame donnée de la deuxième multitrame de cette hypertrame pourra par exemple être affecté à la transmission d'un paquet de linéarisation de l'amplificateur d'émission de l'émetteur 12, ...et ainsi de suite jusqu'à l'intervalle de temps de rang i d'une trame donnée de la n ième multitrame de cette hypertrame qui pourra par exemple être affecté à la transmission d'un paquet de linéarisation de l'amplificateur d'émission de l'émetteur 1n.

D'autres exemples d'affectation, de même que d'autres exemples de structures temporelles, sont bien entendu possibles.

Par ailleurs, l'invention n'est pas limitée à une telle application à un système à accès multiple par répartition temporelle.

Ainsi, dans un système autre qu'un système à accès multiple par répartition temporelle (notamment un système CDMA, ou FDMA), il est créé différents canaux de transmission temporels dits de linéarisation, affectés à la transmission de signaux de linéarisation, tels que ceux notés C1, C2, ...Cn sur la figure 3, et lesdits moyens de commande centralisée 8 sont alors des moyens pour commander l'émission de signaux de linéarisation relatifs à différents amplificateurs d'émission dans des canaux de linéarisation distincts (par exemple l'émission de signaux de linéarisation relatifs à l'émetteur 11 pendant le canal de transmission C1, l'émission de signaux de linéarisation relatifs à l'émetteur 12 pendant le canal de transmission C2, ...,l'émission de signaux de linéarisation relatifs à l'émetteur 1n pendant le canal de transmission C1n).

D'une manière générale, pour regrouper ces différents exemples, il est indiqué que les moyens de commande centralisée sont des moyens pour commander l'émission de signaux de linéarisation relatifs à différents amplificateurs à des moments différents.

Suivant un premier exemple de réalisation, qui peut être illustré par la figure 1, les moyens de commande centralisée 8 comportent des moyens pour allouer des listes disjointes de moments à la transmission de signaux de linéarisation relatifs aux différents amplificateurs d'émission de l'équipement émetteur considéré. Dans l'exemple illustré sur la figure 1, les moyens de commande centralisée 8 sont ainsi utilisés pour commander les moyens de multiplexage tels que les moyens 7 pour l'émetteur 11.

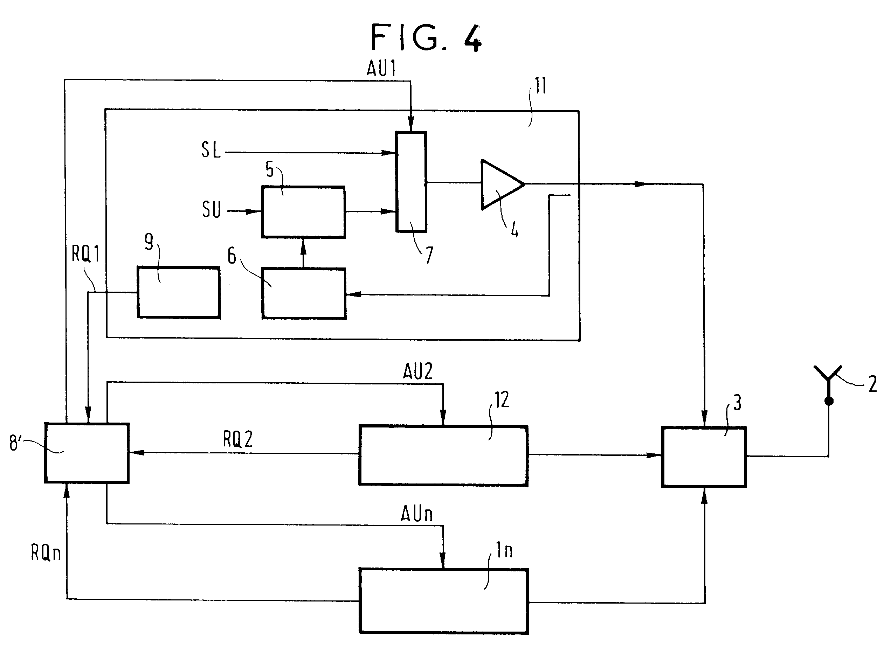

Suivant un autre exemple de réalisation, qui peut être illustré par la figure 4, un émetteur n'est autorisé à émettre un signal de linéarisation qu'après en avoir préalablement fait la requête, et les moyens de commande centralisée, notés alors 8', comportent alors des moyens pour délivrer des autorisations AU1, AU2, ...AUn, en réponse aux requêtes RQ1, RQ2, ...RQn des émetteurs 11, 12, ...1n, de manière à éviter la transmission de paquets de linéarisation relatifs à différents émetteurs pendant un même moment. Des moyens de génération de telles requêtes sont alors prévus dans chaque émetteur, tels que ceux notés 9 pour l'émetteur 11. D'une manière générale, de telles requêtes seront générées suivant les mêmes critères que ceux habituellement utilisés pour déclencher l'émission de signaux de linéarisation par un équipement émetteur, notamment: délai depuis la dernière émission de signaux de linéarisation, variation de température importante, dépassement d'un seuil de température prédéterminé, ...etc. Dans l'exemple illustré, les autorisations AU1, AU2, ...AUn sont appliquées aux différents moyens de multiplexage tels que les moyens 7 pour l'émetteur 11.

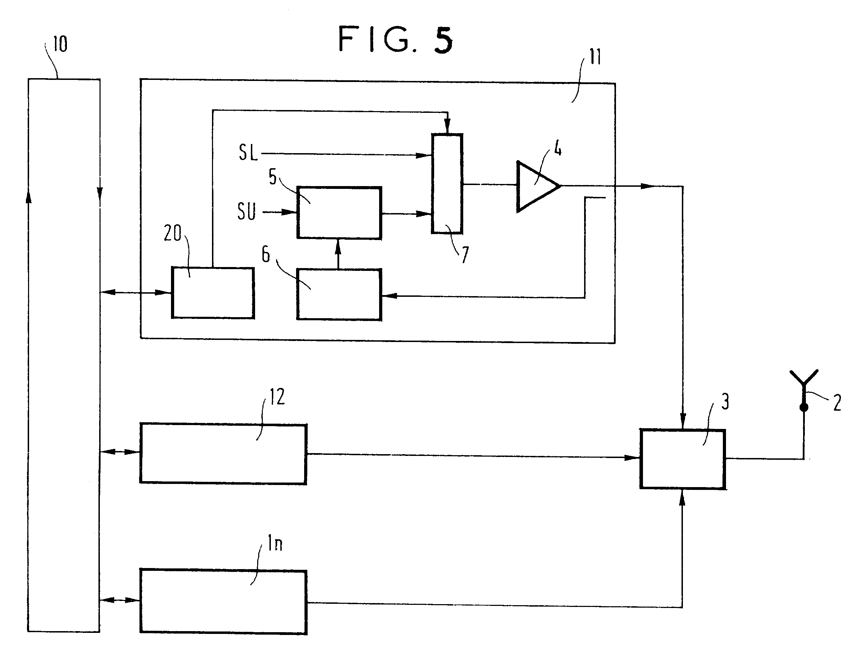

Suivant un autre exemple de réalisation, qui peut être illustré par la figure 5, lesdits moyens de commande centralisée comportent une liaison en anneau 10 reliant entre eux lesdits émetteurs, et des moyens pour faire circuler un jeton sur cet anneau, seul l'émetteur disposant à un moment donné de ce jeton étant autorisé à émettre un signal de linéarisation à ce moment (à la manière de la technique d'accès par jeton à un réseau en anneau). Des moyens d'interface avec cette liaison en anneau sont alors prévus dans chaque émetteur, tels que ceux notés 20 pour l'émetteur 11, ces moyens d'interface fournissant en outre, dans l'exemple illustré, les signaux de commande des différents moyens de multiplexage tels que les moyens 7 pour l'émetteur 11.

Un exposé plus détaillé de la réalisation desdits moyens de commande suivant l'un ou l'autre de ces exemples n'est pas ici nécessaire, une telle réalisation ne posant pas de problème particulier pour l'homme du métier.

On notera simplement que ces moyens de commande, qui sont donc suivant l'invention des moyens de commande permettant de gérer de façon centralisée l'émission de signaux de linéarisation par les différents amplificateurs d'émission de l'équipement émetteur considéré, opèrent avantageusement en synchronisme avec la base de temps de cet équipement émetteur.

## Revendications

1. Dispositif de linéarisation d'amplificateurs d'émission pour équipement émetteur comportant une pluralité d'émetteurs (11, 12, ...n), comportant chacun un amplificateur d'émission (4) et non totalement découplés les uns des autres, ce dispositif comportant des moyens pour commander l'émission de signaux dits de linéarisation relatifs à chaque amplificateur, des moyens (6) pour analyser les signaux de linéarisation amplifiés correspondants, afin de déterminer les non linéarités de cet amplificateur, et d'appliquer à des signaux dits utiles une précorrection (5) destinée à compenser ces non linéarités, et ce dispositif étant caractérisé en en ce qu'il comporte des moyens (8, 8', 10-20) dits de commande centralisée pour commander l'émission de signaux de linéarisation relatifs à différents amplificateurs d'émission à des moments différents.

2. Dispositif selon la revendication 1, caractérisé en ce que ledit équipement émetteur est utilisé dans un système du type à accès multiple par répartition temporelle, utilisant lui-même une structure temporelle de transmission comportant différents canaux de transmission temporels dits logiques, dont un canal logique dit de linéarisation, affecté à la transmission de signaux de linéarisation desdits amplificateurs d'émission, ces canaux logiques se décomposant eux-mêmes en canaux de transmission temporels dits physiques, ou intervalles de temps, dans lesquels peuvent être transmis des éléments de signaux appelés paquets, et en ce que lesdits moyens de commande centralisée (8, 8', 10-20) sont des moyens pour commander l'émission de paquets de linéarisation relatifs à différents amplificateurs d'émission dans des canaux physiques distincts dudit canal logique de linéarisation.

3. Dispositif selon la revendication 1, caractérisé en ce que ledit équipement émetteur est utilisé dans un système autre qu'un système du type à accès multiple par répartition temporelle, en ce qu'il est créé différents canaux de transmission temporels dits de linéarisation, affectés à la transmission de signaux de linéarisation desdits amplificateurs d'émission, et en ce que lesdits moyens de commande centralisée (8, 8', 10-20) sont des moyens pour commander l'émission de signaux de linéarisation relatifs à différents amplificateurs d'émission dans des canaux de linéarisation distincts.

4. Dispositif selon la revendication 1, caractérisé en ce que lesdits moyens de commande centralisée (8) comportent des moyens pour allouer des listes disjointes de moments à la transmission de signaux de linéarisation relatifs à différents amplificateurs d'émission.

5. Dispositif selon la revendication 1, caractérisé en ce que lesdits moyens de commande centralisée (8') comportent des moyens pour délivrer des autorisations (AU1, AU2, ...AUn) d'émission de signaux de linéarisation, en réponse à des requêtes (RQ1, RQ2, ...RQn) des émetteurs, de manière à éviter la transmission de signaux de linéarisation relatifs à différents émetteurs au même moment.

6. Dispositif selon la revendication 1, caractérisé en ce que lesdits moyens de commande centralisée comportent une liaison en anneau (10) reliant entre eux lesdits émetteurs, et des moyens pour faire circuler un jeton sur cet anneau, seul l'émetteur disposant à un moment donné de ce jeton étant autorisé à émettre un signal de linéarisation.
